(19) Europäisches Patentamt
European Patent Office
Office européen des brevets

(11) **EP 4 586 504 A1**

(12) **EUROPEAN PATENT APPLICATION**
published in accordance with Art. 153(4) EPC

(43) Date of publication:
**16.07.2025 Bulletin 2025/29**

(21) Application number: **23896466.2**

(22) Date of filing: **07.11.2023**

(51) International Patent Classification (IPC):
**H04B 1/04** (2006.01)

(52) Cooperative Patent Classification (CPC):
**H04B 1/04**

(86) International application number:
**PCT/CN2023/130131**

(87) International publication number:
**WO 2024/114314 (06.06.2024 Gazette 2024/23)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **29.11.2022 CN 202211517425**

(71) Applicant: **Huawei Technologies Co., Ltd.**
**Shenzhen, Guangdong 518129 (CN)**

(72) Inventors:
• **YANG, Bin**
**Shenzhen, Guangdong 518129 (CN)**
• **WANG, Wei**
**Shenzhen, Guangdong 518129 (CN)**
• **WANG, Fei**
**Shenzhen, Guangdong 518129 (CN)**
• **LI, Zhi**
**Shenzhen, Guangdong 518129 (CN)**

(74) Representative: **Gill Jennings & Every LLP**
**The Broadgate Tower**
**20 Primrose Street**
**London EC2A 2ES (GB)**

(54) **MULTI-CHANNEL NON-LINEARITY CANCELLATION SYSTEM, METHOD AND APPARATUS**

(57)    This application provides a multi-channel non-linearity cancellation system, method, and apparatus. The system includes a digital transmitting module, a first cancellation module, a plurality of second cancellation modules, and a plurality of analog processing modules. The digital transmitting module generates a first radio frequency signal based on a baseband signal. The first cancellation module performs first cancellation processing on the first radio frequency signal based on nonlinear signals fed back by feedback units, to obtain a second radio frequency signal. The second cancellation module performs second cancellation processing on the second radio frequency signal based on the nonlinear signal fed back by the feedback unit in the corresponding analog processing module, to obtain a third radio frequency signal, and sends the third radio frequency signal to an analog transmitting unit in the corresponding connected analog processing module. The first cancellation module addresses a common part of the nonlinear signals sent by the feedback signals, and the second cancellation module addresses a different part of the nonlinear signal sent by the corresponding feedback signal, thereby improving cancellation performance and improving utilization of spectrum resources.

FIG. 2

## Description

CROSS-REFERENCE TO RELATED APPLICATIONS

This application claims priority to Chinese Patent Application No. 202211517425.0, filed with the China National Intellectual Property Administration on November 29, 2022 and entitled "MULTI-CHANNEL NONLINEARITY CANCELLATION SYSTEM, METHOD, AND APPARATUS", which is incorporated herein by reference in its entirety.

TECHNICAL FIELD

This application relates to the field of wireless communication technologies, and in particular, to a multi-channel nonlinearity cancellation system, method, and apparatus.

BACKGROUND

As 5.5G/6G has increasingly high requirements for large bandwidths, an analog device needs to have stronger bandwidth capabilities and support higher frequency bands. However, due to increases in bandwidths and frequencies, nonlinearity (inter modulation Xth, IMDX) and transmission-reception isolation of the analog device gradually deteriorate.

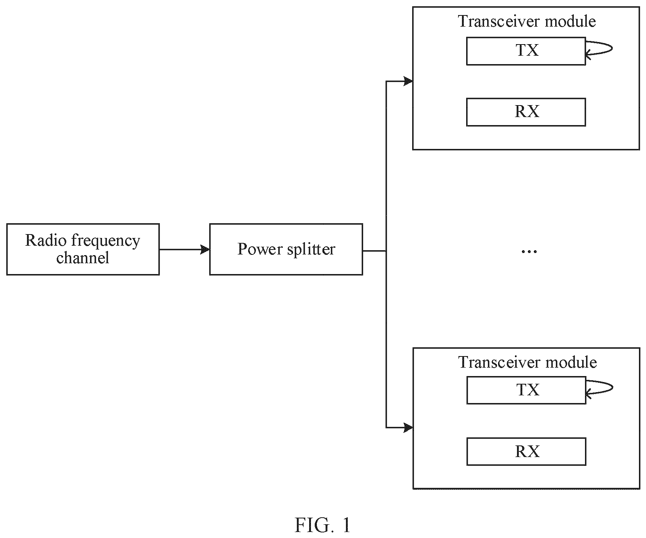

FIG. 1 is a diagram of a current conventional analog device. As shown in FIG. 1, a radio frequency channel in the analog device is configured to perform processing such as amplification and frequency conversion on a radio frequency signal; a power splitter is configured to perform radio frequency splitting on a radio frequency signal from the radio frequency channel; a signal output by the power splitter is sent by a transmitting (transmitting, TX) module (TX for short in the figure and subsequent descriptions) in a transceiver module; and a receiving (receiving, RX) module (RX for short in the figure) is configured to receive an analog signal from external space.

When the analog device transmits a signal, a nonlinear circuit in the analog device generates a nonlinear signal. When two or more signals of different frequencies are input into the nonlinear circuit, many harmonics and combined frequency components are generated due to operations performed by a nonlinear device, and cause interference to a signal transmitted by the TX. Therefore, a frequency of a radio frequency signal can only be between a transmitting frequency and an integer multiple of the transmitting frequency. Currently, the problem of transmission-reception isolation is indirectly resolved by staggering receiving and transmitting spectra, resulting in a waste of a large quantity of spectra.

In view of this, when performance indicators such as isolation and IMDX of an analog device and a transceiver device in a communication device do not meet specification requirements of a hardware system, how to resolve isolation and nonlinearity problems to fully utilize spectrum resources and support evolution to larger bandwidths in future 6G is an urgent problem to be resolved.

SUMMARY

Embodiments of this application provide a multi-channel nonlinearity cancellation system, method, and apparatus, to resolve isolation and nonlinearity problems of an analog device in a communication device, thereby improving utilization of spectrum resources.

According to a first aspect, an embodiment of this application provides a multi-channel nonlinearity cancellation system, including a digital transmitting module, a first cancellation module, a plurality of second cancellation modules, and a plurality of analog processing modules. The plurality of second cancellation modules are connected to the plurality of analog processing modules on a one-to-one basis; each analog processing module includes an analog transmitting unit and a feedback unit that are connected to each other; the analog transmitting unit in any one of the analog processing modules is configured to: convert a received first digital signal into a first analog signal, and transmit the analog signal through an antenna; and the feedback unit in any one of the analog processing modules is configured to: collect a nonlinear signal generated when the connected analog transmitting unit performs digital-to-analog conversion, and feed back the collected nonlinear signal to the first cancellation module and the second cancellation module that corresponds to the analog processing module. The digital transmitting module is configured to: generate a first radio frequency signal based on an input baseband signal, and send the first radio frequency signal to the first cancellation module. The first cancellation module is configured to: perform first cancellation processing on the first radio frequency signal based on the nonlinear signals fed back by the feedback units in the plurality of analog processing modules, to obtain a second radio frequency signal, and send the second radio frequency signal to each second cancellation module. Each second cancellation module is configured to: perform second cancellation processing on the second radio frequency signal based on the nonlinear signal fed back by the feedback unit in the corresponding analog processing module, to obtain a third radio frequency signal, and send the third radio frequency signal to the analog transmitting unit in the corresponding analog processing module. The first radio frequency signal, the second radio frequency signal, and the third radio frequency signal are all first digital signals.

According to the multi-channel nonlinearity cancellation system provided in this application, the first cancellation module and the second cancellation modules can jointly reduce difficulty of maintaining consistency between devices, improve cancellation performance, and meet an isolation metric required by a system. The first cancellation module is configured to address a common part of the nonlinear signals sent by the feedback signals, and the second cancellation modules are configured to address differences between the nonlinear signals sent by the corresponding feedback signals. By use of the first cancellation module and the second cancellation modules, cancellation performance can be improved, and the isolation metric required by the system can be met.

In a possible implementation, the multi-channel nonlinearity cancellation system further includes a combiner. The feedback unit in any one of the analog processing modules is configured to feed back the collected nonlinear signal to the combiner. The combiner is configured to: combine the received nonlinear signals fed back by the feedback units in the plurality of analog processing modules, to generate a combined feedback signal, and send the combined feedback signal to the first cancellation module. The first cancellation module is specifically configured to: determine a first minimum mean square error between the first radio frequency signal and the combined feedback signal; calculate a first nonlinear coefficient based on the first minimum mean square error; and perform the first cancellation processing on the first radio frequency signal based on the first nonlinear coefficient, to obtain the second radio frequency signal. Based on the first nonlinear coefficient, a first nonlinear model can be constructed. The first radio frequency signal is input into the first nonlinear model for the first cancellation processing, to obtain the second radio frequency signal.

In a possible implementation, any one of the second cancellation modules includes a linear predistortion unit and a nonlinearity cancellation unit. The linear predistortion unit is configured to perform linear predistortion on the second radio frequency signal, to obtain a second radio frequency signal obtained through the linear predistortion. The nonlinearity cancellation unit is configured to perform, based on the nonlinear signal fed back by the feedback unit in the corresponding analog processing module, the second cancellation processing on the second radio frequency signal obtained through the linear predistortion, to obtain the third radio frequency signal. Nonlinearities generated by analog devices vary widely. In addition, signals arriving at the analog devices also vary widely because the signals are affected by analog links. The second cancellation modules are configured to address the differences between the nonlinear signals sent by the corresponding feedback signals. The second cancellation module may construct a nonlinear model based on the second radio frequency signal and the nonlinear signal sent by the corresponding feedback signal, calculate a nonlinear coefficient based on a minimum mean square error, and apply the nonlinear coefficient to construction of the nonlinear model. In this way, a difference of overall nonlinearity cancellation is reduced, interference is canceled more thoroughly and more precisely, linearity of the signals is improved, and nonlinear distortion is reduced.

In a possible implementation, the linear predistortion unit is specifically configured to: obtain the first radio frequency signal, and obtain an amplitude parameter, a phase parameter, and a delay parameter based on the nonlinear signal fed back by the feedback unit in the corresponding analog processing module and the first radio frequency signal; and perform the linear predistortion on the second radio frequency signal based on the amplitude parameter, the phase parameter, and the delay parameter, to obtain the second radio frequency signal obtained through the linear predistortion. The amplitude parameter, the phase parameter, and the delay parameter may include an adjustable amplitude value, an adjustable phase value, and an adjustable delay value, respectively. A linear model may be constructed based on the parameters. After the second radio frequency signal is input into the linear model, linear predistortion may be performed on the second radio frequency signal, obtaining the second radio frequency signal obtained through the linear predistortion. In other words, the linear model processes the second radio frequency signal into a distortion-free signal.

In a possible implementation, the nonlinearity cancellation unit is specifically configured to: obtain the first radio frequency signal, and determine a second minimum mean square error between the first radio frequency signal and the nonlinear signal received by the feedback unit in the corresponding analog processing module; calculate a second nonlinear coefficient based on the second minimum mean square error; and perform, based on the second nonlinear coefficient, the second cancellation processing on the second radio frequency signal obtained through the linear predistortion, to obtain the third radio frequency signal.

In a possible implementation, the multi-channel nonlinearity cancellation system further includes a digital receiving module, and each analog processing module further includes an analog receiving unit. The analog receiving unit is configured to: receive a second analog signal through an antenna, convert the second analog signal into a second digital signal, and send the second digital signal to the digital receiving module.

In a possible implementation, the multi-channel nonlinearity cancellation system further includes a power splitter. One end of the power splitter is connected to the first cancellation module, and the other end of the power splitter is connected to each second cancellation module. The power splitter is configured to: receive the second radio frequency signal from the first cancellation module, and send the second radio frequency signal to each second cancellation module.

In a possible implementation, each analog transmitting unit includes a digital-to-analog conversion circuit and a power amplification circuit. The digital-to-analog conversion circuit is configured to convert the first digital signal into the first analog signal. The power amplification circuit is configured to amplify power of the first analog signal.

According to a second aspect, this application provides a multi-channel nonlinearity cancellation method. The method includes: generating a first radio frequency signal based on an input baseband signal, and sending the first radio frequency signal to a first cancellation module; performing first cancellation processing on the first radio frequency signal based on nonlinear signals fed back by feedback units in a plurality of analog processing modules, to obtain a second radio frequency signal, and sending the second radio frequency signal to each second cancellation module; and performing second cancellation processing on the second radio frequency signal based on the nonlinear signal fed back by the feedback unit in the corresponding analog processing module, to obtain a third radio frequency signal, and sending the third radio frequency signal to an analog transmitting unit in the corresponding analog processing module.

In a possible implementation, the performing first cancellation processing on the first radio frequency signal based on nonlinear signals fed back by feedback units in a plurality of analog processing modules, to obtain a second radio frequency signal includes: combining the received nonlinear signals fed back by the feedback units in the plurality of analog processing modules, to generate a combined feedback signal; determining a first minimum mean square error between the first radio frequency signal and the combined feedback signal; calculating a first nonlinear coefficient based on the first minimum mean square error; and performing the first cancellation processing on the first radio frequency signal based on the first nonlinear coefficient, to obtain the second radio frequency signal.

In a possible implementation, the performing second cancellation processing on the second radio frequency signal based on a nonlinear signal fed back by a feedback unit in a corresponding analog processing module includes: performing linear predistortion on the second radio frequency signal, to obtain a second radio frequency signal obtained through the linear predistortion; and performing, based on the nonlinear signal fed back by the feedback unit in the corresponding analog processing module, the second cancellation processing on the second radio frequency signal obtained through the linear predistortion, to obtain the third radio frequency signal.

In a possible implementation, the performing linear predistortion on the second radio frequency signal, to obtain a second radio frequency signal obtained through the linear predistortion includes: obtaining the first radio frequency signal, and obtaining an amplitude parameter, a phase parameter, and a delay parameter based on the nonlinear signal fed back by the feedback unit in the corresponding analog processing module and the first radio frequency signal; and performing the linear predistortion on the second radio frequency signal based on the amplitude parameter, the phase parameter, and the delay parameter, to obtain the second radio frequency signal obtained through the linear predistortion.

In a possible implementation, the performing, based on the nonlinear signal fed back by the feedback unit in the corresponding analog processing module, the second cancellation processing on the second radio frequency signal obtained through the linear predistortion, to obtain the third radio frequency signal includes: obtaining the first radio frequency signal, and determining a second minimum mean square error between the first radio frequency signal and the nonlinear signal received by the feedback unit in the corresponding analog processing module; calculating a second nonlinear coefficient based on the second minimum mean square error; and performing, based on the second nonlinear coefficient, the second cancellation processing on the second radio frequency signal obtained through the linear predistortion, to obtain the third radio frequency signal.

In a possible implementation, the method further includes: receiving a second analog signal through an antenna, converting the second analog signal into a second digital signal, and sending the second digital signal to a digital receiving module.

According to a third aspect, this application provides a multi-channel nonlinearity cancellation apparatus. The apparatus may include modules that perform and one-to-one correspond to the methods/operations/-steps/actions described in the first aspect. The modules may be implemented by hardware circuits, software, or a combination of hardware circuits and software. In a design, the apparatus may include a processing module and a communication module.

The processing module is configured to: generate a first radio frequency signal based on an input baseband signal, and send the first radio frequency signal to a first cancellation module; perform first cancellation processing on the first radio frequency signal based on nonlinear signals fed back by feedback units in a plurality of analog processing modules, to obtain a second radio frequency signal, and send the second radio frequency signal to each second cancellation module; and perform second cancellation processing on the second radio frequency signal based on the nonlinear signal fed back by the feedback unit in the corresponding analog processing module, to obtain a third radio frequency signal, and send the third radio frequency signal to an analog transmitting unit in the corresponding analog processing module. The communication module is configured to send the third radio frequency signal to external space through an antenna.

According to a fourth aspect, an embodiment of this application further provides a computer program. When the computer program is run on a computer, the computer is enabled to perform the method according to the second aspect.

According to a fifth aspect, an embodiment of this application further provides a computer program product, including instructions. When the instructions are run on a computer, the computer is enabled to perform the method according to the second aspect.

According to a sixth aspect, an embodiment of this application further provides a computer-readable storage medium. The computer-readable storage medium stores a computer program or instructions. When the computer program or instructions are run on a computer, the computer is enabled to perform the method according to the second aspect.

According to a seventh aspect, an embodiment of this application further provides a chip. The chip is configured to perform the method according to the second aspect. Optionally, the chip is configured to read a computer program stored in a memory, to perform the method according to the second aspect.

According to an eighth aspect, an embodiment of this application further provides a chip system. The chip system includes a processor, configured to support a computer apparatus to implement the method according to the second aspect. In a possible design, the chip system further includes a memory. The memory is configured to store a program and data that are necessary for the computer apparatus. The chip system may include a chip, or may include a chip and another discrete component.

For effects of the solutions provided in any one of the second aspect to the eighth aspect, refer to the corresponding descriptions in the first aspect.

BRIEF DESCRIPTION OF DRAWINGS

FIG. 1 is a diagram of reception and transmission of an analog device;
FIG. 2 is a diagram 1 of a multi-channel nonlinearity cancellation system;
FIG. 3 is a diagram 2 of a multi-channel nonlinearity cancellation system;
FIG. 4 is a diagram 3 of a multi-channel nonlinearity cancellation system;
FIG. 5 is a diagram 4 of a multi-channel nonlinearity cancellation system;
FIG. 6 is a diagram 5 of a multi-channel nonlinearity cancellation system;
FIG. 7 is a flowchart of a multi-channel nonlinearity cancellation method; and
FIG. 8 is a diagram of a structure of a multi-channel nonlinearity cancellation apparatus.

DESCRIPTION OF EMBODIMENTS

To make objectives, technical solutions, and advantages of embodiments of this application clearer, the following further describes embodiments of this application in detail with reference to the accompanying drawings.

In the following descriptions of embodiments of this application, at least one indicates one or more; a plurality of indicates two or more; "and/or" describes an association between associated objects, and indicates that three relationships may exist, where for example, A and/or B may indicate the following three cases: only A exists, both A and B exist, and only B exists; and the character "/" usually indicates an "or" relationship between associated objects. In addition, it should be understood that although terms such as first and second may be used in embodiments of this application to describe objects, the objects shall not be limited to these terms. These terms are merely used to distinguish the objects from each other.

Terms "include", "have", and any variant thereof mentioned in the following descriptions of embodiments of this application are intended to cover a non-exclusive inclusion. For example, a process, method, system, product, or device that includes a series of steps or units is not limited to listed steps or units, but optionally further includes another unlisted step or unit, or optionally further includes another step or unit inherent in the process, method, product, or device. It should be noted that in embodiments of this application, an expression such as "example" or "for example" is used to represent giving an example, an illustration, or a description. Any method or design solution described as an "example" or "for example" in embodiments of this application should not be explained as being more preferred or having more advantages than another method or design solution. To be precise, use of the expression such as "example" or "for example" is intended to present a related concept in a specific manner.

Technologies provided in embodiments of this application may be used in various communication systems. For example, the communication system may be a 3rd generation (3rd generation, 3G) communication system (for example, a universal mobile telecommunications system (universal mobile telecommunications system, UMTS)), a 4th generation (4th generation, 4G) communication system (for example, a long term evolution (long term evolution, LTE) system), a 5th generation (5th generation, 5G) communication system, a worldwide interoperability for microwave access (worldwide interoperability for microwave access, WiMAX) or wireless local area network (wireless local area network, WLAN) system, a system integrating a plurality of systems, or a future communication system, for example, a 6th generation (6th generation, 6G) communication system. The 5G communication system may also be referred to as a new radio (new radio, NR) system.

In a wireless communication system, to meet requirements for transmitting a signal, an analog device needs to amplify power. As 5.5G/6G has increasingly high requirements for large bandwidths, an analog device needs to have stronger bandwidth capabilities and support higher frequency bands. As a result, nonlinearity and transmission-reception isolation of the analog device gradually deteriorate. In view of this, this application provides a multi-channel nonlinearity cancellation system. By use of multi-level cancellation modules, difficulty of maintaining consistency between nonlinearity cancellations performed by devices is reduced, and existing isolation and nonlinearity problems are resolved, fully utilizing spectrum resources.

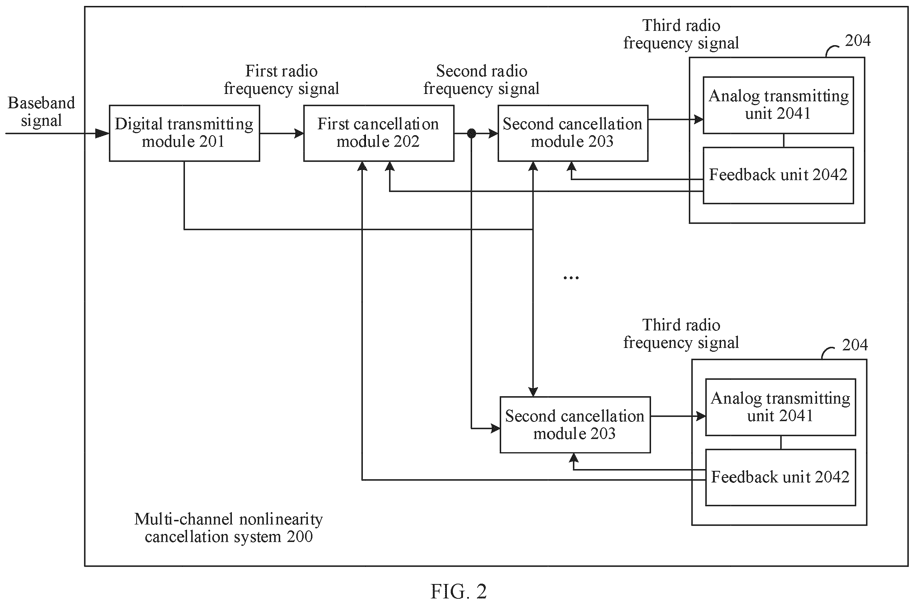

FIG. 2 is a diagram 1 of a multi-channel nonlinearity cancellation system according to this application. As shown in FIG. 2, the multi-channel nonlinearity cancellation system 200 includes a digital transmitting module 201, a first cancellation module 202, a plurality of second cancellation modules 203, and a plurality of analog processing modules 204. The plurality of second cancellation modules 203 are connected to the plurality of analog processing modules 204 on a one-to-one basis. Each analog processing module 204 includes an analog transmitting unit 2041 and a feedback unit 2042 that are connected to each other. The analog transmitting unit 2041 is configured to: convert a received first digital signal into a first analog signal, and transmit the first analog signal through an antenna. The feedback unit 2042 is configured to: collect a nonlinear signal generated when the connected analog transmitting unit 2041 performs digital-to-analog conversion, and feed back the collected nonlinear signal to the first cancellation module and the second cancellation module that corresponds to the analog processing module.

The digital transmitting module 201 is configured to: generate a first radio frequency signal based on an input baseband signal, and send the first radio frequency signal to the first cancellation module 202.

The first cancellation module 202 is configured to: perform first cancellation processing on the first radio frequency signal based on the nonlinear signals fed back by the feedback units 2042 in the plurality of analog processing modules 204, to obtain a second radio frequency signal, and send the second radio frequency signal to each second cancellation module 203.

Each second cancellation module 203 is configured to: perform second cancellation processing on the second radio frequency signal based on the nonlinear signal fed back by the feedback unit 2042 in the corresponding analog processing module 204, to obtain a third radio frequency signal, and send the third radio frequency signal to the analog transmitting unit 2041 in the corresponding connected analog processing module 204. The first radio frequency signal, the second radio frequency signal, and the third radio frequency signal are all first digital signals.

The digital transmitting module 201, the first cancellation module 202, the plurality of second cancellation modules 203, and the plurality of analog processing modules 204 may all be disposed in a transmitter of a network device or user equipment. The transmitter may include at least one transmitting channel. Each transmitting channel is configured to send baseband signals to the digital transmitting module 201. The digital transmitting module 201, the first cancellation module 202, the plurality of second cancellation modules 203, and the plurality of analog processing modules 204 may be connected to each other by optical fibers.

Baseband signals may be further classified into digital baseband signals and analog baseband signals. The analog transmitting unit 2041 may be a remote radio unit (remote radio unit, RRU), a pico remote radio unit (pico remote radio unit, pRRU), an active antenna unit (active antenna unit, AAU), another unit, module, or device with radio frequency processing functions, or the like. It can be understood that the analog transmitting unit 2041 is responsible for transmitting radio signals. The analog transmitting unit 2041 may also have some of baseband functions. To be specific, baseband functions close to radio frequencies may be migrated to the analog transmitting unit 2041 for implementation. For example, the analog transmitting unit 2041 may implement at least one of the following functions: fast Fourier transform (fast Fourier transform, FFT)/inverse fast Fourier transformation (inverse fast Fourier transformation, iFFT), beamforming, extraction and filtering of a physical random access channel (physical random access channel, PRACH), and the like.

A device configured to implement an analog transmission function may be the analog transmitting unit 2041, or a device with some of functions of the analog transmitting unit 2041, or an apparatus capable of supporting the analog transmitting unit 2041 to implement the function, such as a chip system, a hardware circuit, a software module, or a combination of a hardware circuit and a software module. The apparatus may be installed in the analog transmitting unit 2041. In the system in this embodiment of this application, the analog transmitting unit 2041 is used as an example for description.

The analog transmitting unit 2041 in the analog processing module 204 may specifically include analog devices such as a digital-to-analog converter (digital-to-analog converter, DAC) and a power amplifier (power amplifier, PA). The digital-to-analog converter is configured to convert the received first digital signal into the first analog signal (convert a signal of a digital type into a signal of an analog type). To meet requirements for transmitting a signal, the power amplifier needs to amplify power and then send the signal to wireless space. The power amplifier operates in its nonlinear region when amplifying the signal. Nonlinearities of the nonlinear region cause problems such as harmonic distortion and intermodulation distortion that result from amplitude distortion and phase distortion.

Therefore, to avoid nonlinear distortion caused by power amplification, the analog transmitting unit 2041 in the analog processing module 204 feeds back an output signal to the feedback unit 2042. The feedback unit 2042 may collect the nonlinear signal generated by the connected analog transmitting unit 2041, and feed back the nonlinear signal to the first cancellation module 202 and the second cancellation module 203 that corresponds to the analog processing module 204.

Optionally, because the power of the signal on which power amplification is performed is high, the signal output by the analog transmitting unit 2041 may be coupled to the feedback unit 2042 by configuring a coupler, reducing the power of the signal and increasing a processing speed.

Optionally, the feedback unit 2042 may include an analog-to-digital converter (analog-to-digital converter, ADC). The analog-to-digital converter can exist in the feedback unit 2042 in a plurality of forms. For example, the ADC may be integrated in the feedback unit 2042 in a form of software and/or hardware; or the ADC may be separate from the feedback unit 2042, and be located between the analog transmitting unit 2041 and the feedback unit 2042; or the ADC may be separate from the feedback unit 2042, and be located between the feedback unit 2042 and the corresponding first cancellation module 202 and/or second cancellation module 203.

In addition, during processing and transmission of signals of the analog type, secondary interfering signals are likely generated. Therefore, in this embodiment of this application, the second cancellation module 203 may process signals of the digital type. To be specific, the feedback unit 2042 and the analog transmitting unit 2041 may be specifically connected via an ADC.

Signals received by the feedback unit 2042 may include a feedback signal corresponding to the signal transmitted by the analog transmitting unit 2041, and an interfering signal generated due to nonlinear interference that is caused by the analog transmitting unit 2041, and further, may include an interfering signal generated due to interference that is caused by another analog transmitting unit 2041 other than the analog transmitting unit 2041. In other words, in this case, the signals received by the feedback unit 2042 are mixed signals that include a plurality of signals. It should be noted that the feedback signal corresponding to the signal transmitted by the analog transmitting unit 2041 is a nonlinear signal generated by the power amplifier in the analog transmitting unit 2041.

The first cancellation module 202 is configured to: perform first cancellation processing on the first radio frequency signal based on the nonlinear signals fed back by the feedback units 2042 in the plurality of analog processing modules 204, to obtain a second radio frequency signal, and send the second radio frequency signal to each second cancellation module 203.

The first cancellation module 202 may be coupled to the feedback units 2042 in the plurality of analog processing modules 204, and receives the nonlinear signals fed back by the feedback units 2042 in the plurality of analog processing modules 204. The different nonlinear signals are highly similar and highly correlated. Therefore, the first cancellation module 202 may be configured to address a common part of the nonlinear signals generated by the analog transmitting units 2041, and cancel the common part of the nonlinear signals, to implement overall nonlinearity cancellation, improve cancellation performance, and meet an isolation metric of a communication system.

When the first cancellation processing is performed on the first radio frequency signal based on the nonlinear signals fed back by the feedback units 2042 in the plurality of analog processing modules 204, an adaptive solving criterion or method such as least mean square (least mean square, LMS), least square (least square, LS), or recursive least square (recursive least Square, RLS) may be specifically used to perform the cancellation. The first cancellation module 202 may be an integrated circuit or chip capable of implementing the foregoing functions, or may be a processor with the foregoing functions integrated.

The second cancellation module 203 is configured to: perform second cancellation processing on the second radio frequency signal based on the nonlinear signal fed back by the feedback unit 2042 in the corresponding analog processing module 204, to obtain a third radio frequency signal, and send the third radio frequency signal to the analog transmitting unit 2041 in the corresponding analog processing module 204.

Nonlinear components generated by the analog devices in the analog processing modules 204 vary widely. In addition, because signals are transmitted over analog links, the signals vary widely in a group delay and amplitude unflatness when arriving at the analog devices in the analog processing modules 204, and generated IMDX components also vary widely.

Therefore, the second cancellation modules 203 may be coupled to the corresponding feedback units 2042, and receive the nonlinear signals sent by the feedback units 2042, to address differences between the nonlinear signals generated by the different analog transmitting units 2041. In this way, the differences between the nonlinear signals are canceled at the second cancellation modules 203 respectively corresponding to the feedback units 2042, to reduce differences between the nonlinearity cancellations, improve cancellation performance, and meet the isolation metric of the communication system.

For example, when the second cancellation processing is performed on the second radio frequency signal based on the corresponding nonlinear signal, an adaptive solving criterion or method such as least mean square, least square, or recursive least square may also be used to perform the cancellation. Persons skilled in the art should know a specific manner, and therefore details are not described herein. The second cancellation module 203 may be an integrated circuit or chip capable of implementing the foregoing functions, or may be a processor with the foregoing functions integrated.

Although only the nonlinear interference cancellation solution for one digital transmitting module 201 is shown in this embodiment of this application, an interference cancellation solution for another digital transmitting module 201 in the transmitter is similar to the foregoing structure. If the transmitter includes at least two digital transmitting modules 201 and a plurality of analog processing modules 204, modules connected to each digital transmitting module 201 may include one first cancellation module 202 and a plurality of second cancellation modules 203 correspondingly. Details are not described herein.

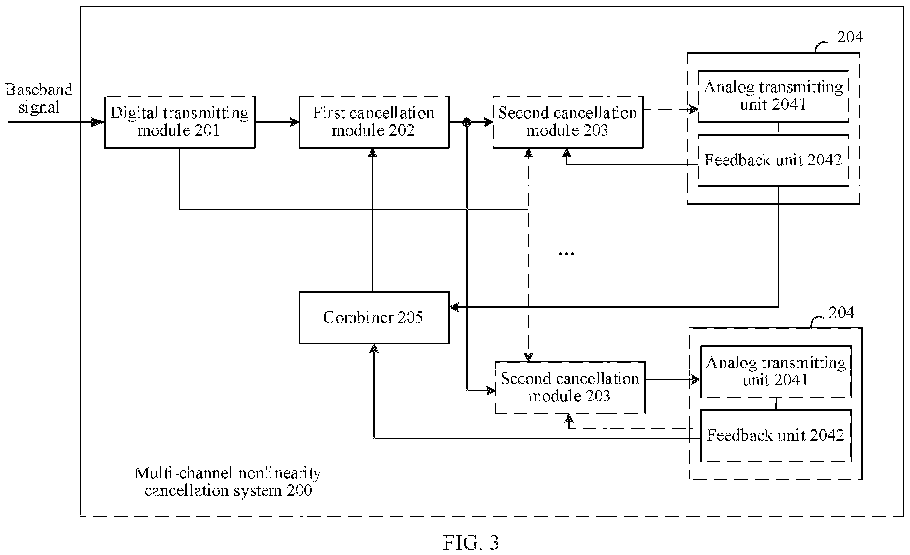

FIG. 3 is a diagram 2 of a multi-channel nonlinearity cancellation system according to this application. As shown in FIG. 3, based on the structure of the multi-channel nonlinearity cancellation system shown in FIG. 2, the multi-channel nonlinearity cancellation system further includes a combiner 205. The feedback unit 2042 in any one of the analog processing modules 204 is configured to feed back the collected nonlinear signal to the combiner 205. The combiner 205 is configured to: combine the received nonlinear signals collected by the feedback units 2042 in the plurality of analog processing modules 204, to generate a combined feedback signal, and send the combined feedback signal to the first cancellation module 202. The first cancellation module 202 is specifically configured to: determine a first minimum mean square error between the first radio frequency signal and the combined feedback signal; calculate a first nonlinear coefficient based on the first minimum mean square error; and perform the first cancellation processing on the first radio frequency signal based on the first nonlinear coefficient, to obtain the second radio frequency signal.

The combiner 205 may specifically include a single-pole multi-state switch. The switch in the combiner 205 may be connected to the feedback units 2042 separately. When a single pole of the single-pole multi-state switch is switched to a first state, a first feedback unit 2042 in the plurality of analog processing modules 204 can be connected to the combiner 205, to receive a nonlinear signal fed back by the first feedback unit 2042; when the single pole of the single-pole multi-state switch is switched to a second state, a second feedback unit 2042 in the plurality of analog processing modules 204 can be connected to the combined feedback signal, to receive a nonlinear signal fed back by the second feedback unit 2042; and so on. The combined feedback signal is determined based on the different nonlinear signals that are fed back by the feedback units 2042 and that are received separately. Alternatively, the combiner 205 may directly generate the combined feedback signal based on the received nonlinear signals collected by the feedback units 2042.

After determining the combined feedback signal, the combiner 205 may send the combined feedback signal to the first cancellation module 202. The first cancellation module 202 determines the first minimum mean square error between the first radio frequency signal and the combined feedback signal; calculates the first nonlinear coefficient based on the first minimum mean square error; and constructs a first nonlinear model based on the first nonlinear coefficient, and inputs the first radio frequency signal into the first nonlinear model, to obtain the second radio frequency signal. The first nonlinear model is configured to perform the first cancellation processing on the input first radio frequency signal.

The first cancellation module 202 is configured to address the common part of the nonlinear signals sent by the feedback signals. Specifically, the first cancellation module 202 may construct a nonlinear model based on the first radio frequency signal and the combined feedback signal, calculate a nonlinear coefficient based on a minimum mean square error, and apply the nonlinear coefficient to construction of the nonlinear model. In this way, predistortion cancellation is implemented.

A formula executed in the model is as follows:

$$f(x) = a0 \times xn + a1 \times x^{\wedge}(n-1) + \ldots a(n-1) \times x + an,$$

, where x is an input signal of the first cancellation module 202, n is an amount of delay of different times, and a is an amplitude-phase coefficient. The first nonlinear coefficient can be updated in real time based on the first minimum mean square error.

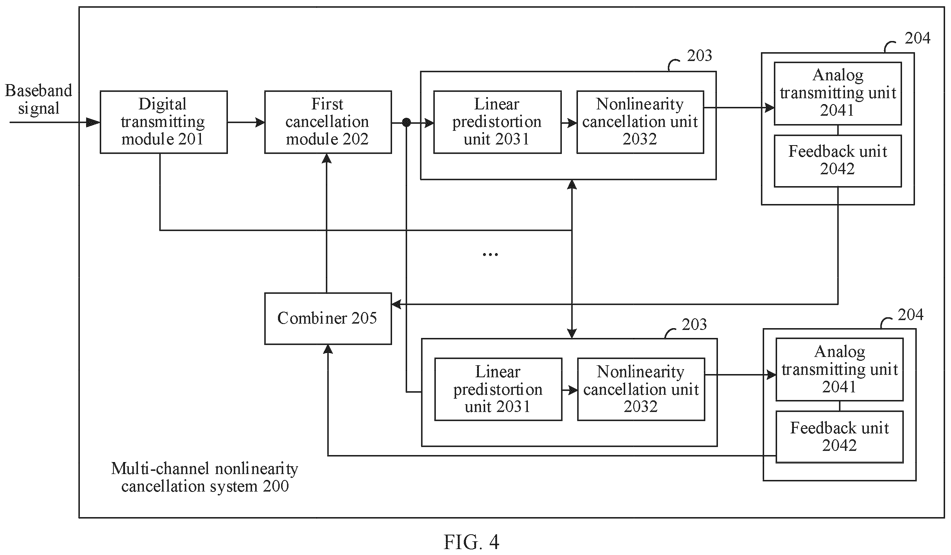

In a possible implementation, as shown in FIG. 4, the second cancellation module 203 specifically includes a linear predistortion unit 2031 and a nonlinearity cancellation unit 2032. The linear predistortion unit 2031 is configured to perform linear predistortion on the second radio frequency signal, to obtain a second radio frequency signal obtained through the linear predistortion. The nonlinearity cancellation unit 2032 is configured to perform, based on the nonlinear signal fed back by the feedback unit 2042 in the corresponding analog processing module 204, the second cancellation processing on the second radio frequency signal obtained through the linear predistortion, to obtain the third radio frequency signal.

The linear predistortion unit 2031 is configured to: obtain an amplitude parameter, a phase parameter, and a delay parameter based on the nonlinear signal fed back by the feedback unit 2042 in the corresponding analog processing module 204 and the first radio frequency signal; and perform the linear predistortion on the second radio frequency signal based on the amplitude parameter, the phase parameter, and the delay parameter, to obtain the second radio frequency signal obtained through the linear predistortion.

The amplitude parameter, the phase parameter, and the delay parameter may include an adjustable amplitude value, an adjustable phase value, and an adjustable delay value, respectively. A linear model may be constructed based on the parameters. After the second radio frequency signal is input into the linear model, linear predistortion may be performed on the second radio frequency signal, obtaining the second radio frequency signal obtained through the linear predistortion. In other words, the linear model processes the second radio frequency signal into a distortion-free signal. The linear predistortion unit 2031 may be a digital predistortion device or an analog predistortion device. This is not specifically limited herein.

The nonlinearity cancellation unit 2032 is specifically configured to: determine a second minimum mean square error between the first radio frequency signal and the nonlinear signal received by the feedback unit 2042 in the corresponding analog processing module 204; calculate a second nonlinear coefficient based on the second minimum mean square error; and perform, based on the second nonlinear coefficient, the second cancellation processing on the second radio frequency signal obtained through the linear predistortion, to obtain the third radio frequency signal.

IMDX cancellation components generated by the analog devices vary widely. In addition, signals arriving at the analog devices also vary widely because the signals are affected by analog links. The second cancellation modules 203 may address the differences between the nonlinear signals sent by the corresponding feedback units 2042. Specifically, the second cancellation module 203 may construct a nonlinear model based on the second radio frequency signal and the nonlinear signal sent by the corresponding feedback unit 2042. The second minimum mean square error between the first radio frequency signal and the nonlinear signal received by the feedback unit 2042 in the corresponding analog processing module 204 is determined, and the second nonlinear coefficient is calculated based on the second minimum mean square error.

A second nonlinear model is constructed based on the second nonlinear coefficient, and the second radio frequency signal obtained through the linear predistortion is input into the second nonlinear model, to obtain the second radio frequency signal. The second nonlinear model is configured to perform the second cancellation processing on the input second radio frequency signal obtained through the linear predistortion. In this way, a difference of overall nonlinearity cancellation is reduced, interference is canceled more thoroughly and more precisely, linearity of the signals is improved, and nonlinear distortion is reduced. For a process of inputting the second radio frequency signal obtained through the linear predistortion into the second nonlinear model, refer to the manner in the foregoing embodiment. Details are not described herein again.

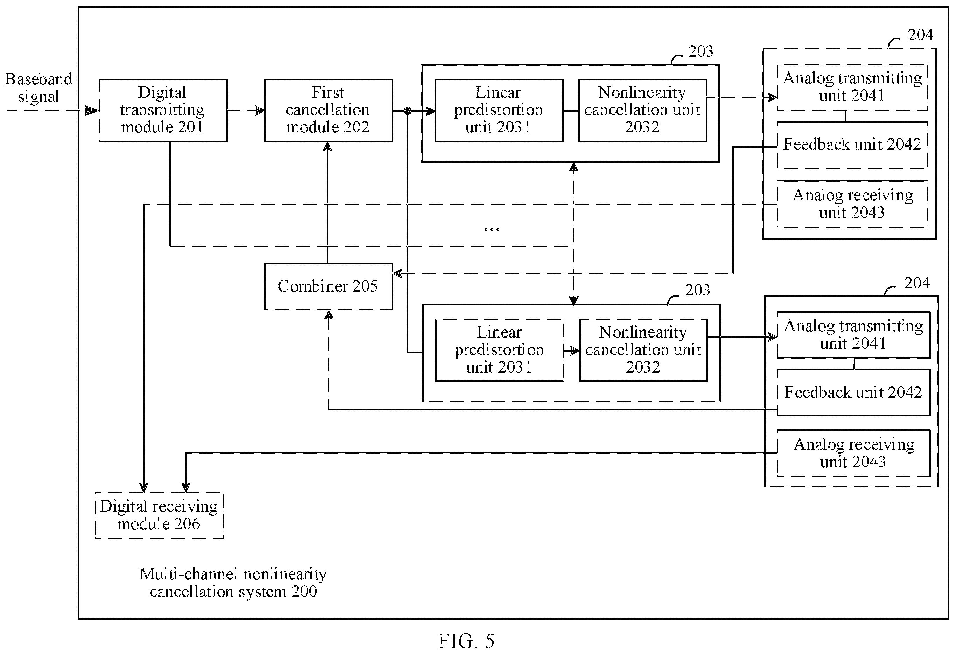

In a possible implementation, as shown in FIG. 5, the multi-channel nonlinearity cancellation system further includes a digital receiving module 206, and each analog processing module 204 further includes an analog receiving unit 2043. The analog receiving unit 2043 is configured to: receive a second analog signal through an antenna, convert the second analog signal into a second digital signal, and send the second digital signal to the digital receiving module 206. It can be understood that the analog receiving unit 2043 is responsible for receiving radio signals.

The analog receiving unit 2043 may include an analog-to-digital converter, configured to convert the first analog signal into the first digital signal and send the first digital signal to the digital receiving module 206. In addition, after the analog transmitting unit 2041 sends a signal, the analog receiving unit 2043 suffers interference caused by the analog transmitting unit because nonlinearities and electromagnetic radiation are generated during analog processing. Therefore, likewise, a cancellation module may be disposed between the digital receiving module 206 and the digital transmitting unit, to cancel interference caused by the analog transmitting unit to the analog receiving unit 2043. Decomposition and cancellation may be performed on a digital signal received by the digital receiving module 206. Based on the first radio frequency signal sent by the digital transmitting unit, the digital signal received by the digital receiving module 206 is decomposed, and a first radio frequency signal component in the digital signal is filtered out. In this way, interference caused by the analog transmitting unit to the analog receiving unit 2043 is reduced.

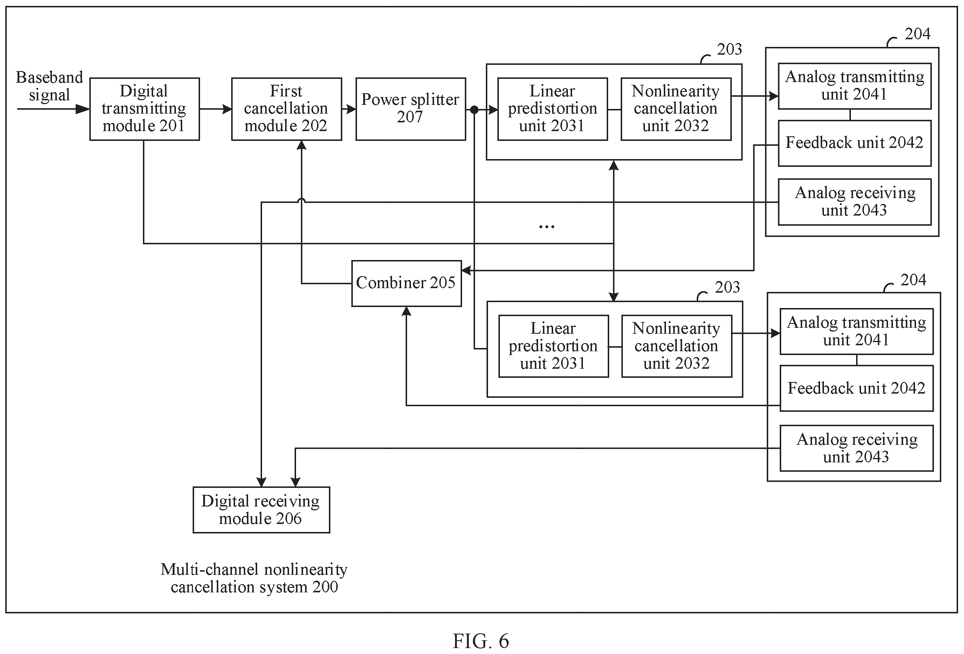

In a possible implementation, as shown in FIG. 6, the multi-channel nonlinearity cancellation system may further include a power splitter 207. One end of the power splitter 207 is connected to the first cancellation module 202, and the other end of the power splitter 207 is connected to each second cancellation module 203. The power splitter 207 is configured to: receive the second radio frequency signal from the first cancellation module, and send the second radio frequency signal to each second cancellation module 203.

A specific degree of isolation is set between output ports of the power splitter 207. The power splitter 207 is configured to split one channel of input signals into two or more channels for output. One end of the power splitter 207 is specifically configured to be connected to the first cancellation module 202, and the other end of the power splitter 207 is specifically configured to be connected to each second cancellation module 203.

According to the multi-channel nonlinearity cancellation system provided in this application, the first cancellation module 202 and the second cancellation modules 203 can reduce difficulty of maintaining consistency between devices, improve cancellation performance, and meet the isolation metric required by the system. The first cancellation module 202 is configured to address the common part of the nonlinear signals sent by the feedback signals. Specifically, the first cancellation module 202 may construct a nonlinear model based on the first radio frequency signal and the combined feedback signal, calculate the first nonlinear coefficient based on a minimum mean square error, and apply the first nonlinear coefficient to construction of the nonlinear model. In this way, predistortion cancellation is implemented. The second cancellation modules 203 are configured to address the differences between the nonlinear signals sent by the corresponding feedback signals. Specifically, the second cancellation module 203 may construct a nonlinear model based on the second radio frequency signal and the nonlinear signal sent by the corresponding feedback signal, calculate the second nonlinear coefficient based on a minimum mean square error, and apply the second nonlinear coefficient to construction of the nonlinear model. In this way, a difference of overall nonlinearity cancellation is reduced, cancellation performance is improved, and the isolation metric required by the system is met. In addition, it is avoided that the first cancellation module 202 and the second cancellation modules 203 are implemented at a head end of the system, reducing costs.

It should be noted that the foregoing embodiments are applicable to systems such as a mobile communication network, a fixed/radio access network, wireless data transmission, and radar. A specific scenario is not limited herein.

Any one of the first cancellation module 202 and the second cancellation modules 203 in embodiments of this application may be specifically implemented by an integrated circuit or chip that integrates functions of the corresponding module, or may be implemented by a combination of a memory and a processor. If being implemented by a combination of a memory and a processor, the first cancellation module 202 and the second cancellation modules 203 may include at least one memory and a processor. The memory may store computer-executable instructions that implement functions of a corresponding module, so that the processor connected to the memory invokes and executes the computer-executable instructions.

In embodiments of this application, a communication device may be a base station or a wireless terminal. A wireless terminal may be a device that provides a user with voice and/or data connectivity, a handheld device with a wireless connectivity function, or another processing device connected to a wireless modem. The wireless terminal may communicate with one or more core networks through a radio access network (for example, RAN, radio access network). The wireless terminal may be a mobile terminal, such as a mobile phone (or referred to as a "cellular" phone), or a computer with a mobile terminal. For example, the wireless terminal may be a portable, pocket-sized, handheld, computer built-in, or vehicle-mounted mobile apparatus, which exchanges voice and/or data with a radio access network. For example, the wireless terminal may be a device such as a personal communication service (Personal communication service, PCS) phone, a cordless phone, a session initiation protocol (SIP) phone, a wireless local loop (wireless local loop, WLL) station, or a personal digital assistant (personal digital assistant, PDA). The wireless terminal may also be referred to as a subscriber unit (subscriber unit), a subscriber station (subscriber station), a mobile station (mobile station), a mobile console (mobile), a remote station (remote station), an access point (access point), a remote terminal (remote terminal), an access terminal (access terminal), a user terminal (user terminal), a user agent (user agent), a user device (user device), or user equipment (user equipment). For a GSM system, a base station may include a base transceiver station (base transceiver Station, BTS) and/or a base station controller (base station controller, BSC). For a TD-SCDMA system and a WCDMA system, a base station may include a NodeB (nodeB, NB) and/or a radio network controller (radio network controller, RNC). For an LTE system, a base station may be an eNB.

Based on the foregoing embodiments, this application provides a multi-channel nonlinearity cancellation method. The method includes: generating a first radio frequency signal based on an input baseband signal, and sending the first radio frequency signal to a first cancellation module; performing first cancellation processing on the first radio frequency signal based on nonlinear signals fed back by feedback units in a plurality of analog processing modules, to obtain a second radio frequency signal, and sending the second radio frequency signal to each second cancellation module; and performing second cancellation processing on the second radio frequency signal based on the nonlinear signal fed back by the feedback unit in the corresponding analog processing module, to obtain a third radio frequency signal, and sending the third radio frequency signal to an analog transmitting unit in the corresponding analog processing module.

In a possible implementation, the performing first cancellation processing on the first radio frequency signal based on nonlinear signals fed back by feedback units in a plurality of analog processing modules, to obtain a second radio frequency signal includes: combining the received nonlinear signals fed back by the feedback units in the plurality of analog processing modules, to generate a combined feedback signal; and determining a first minimum mean square error between the first radio frequency signal and the combined feedback signal; and

calculating a first nonlinear coefficient based on the first minimum mean square error; and performing the first cancellation processing on the first radio frequency signal based on the first nonlinear coefficient, to obtain the second radio frequency signal.

In a possible implementation, the performing second cancellation processing on the second radio frequency signal based on a nonlinear signal fed back by a feedback unit in a corresponding analog processing module includes: performing linear predistortion on the second radio frequency signal, to obtain a second radio frequency signal obtained through the linear predistortion; and performing, based on the nonlinear signal fed back by the feedback unit in the corresponding analog processing module, the second cancellation processing on the second radio frequency signal obtained through the linear predistortion, to obtain the third radio frequency signal.

In a possible implementation, the performing linear predistortion on the second radio frequency signal, to obtain a second radio frequency signal obtained through the linear predistortion includes: obtaining the first radio frequency signal, and obtaining an amplitude parameter, a phase parameter, and a delay parameter based on the nonlinear signal fed back by the feedback unit in the corresponding analog processing module and the first radio frequency signal; and performing the linear predistortion on the second radio frequency signal based on the amplitude parameter, the phase parameter, and the delay parameter, to obtain the second radio frequency signal obtained through the linear predistortion.

In a possible implementation, the performing, based on the nonlinear signal fed back by the feedback unit in the corresponding analog processing module, the second cancellation processing on the second radio frequency signal obtained through the linear predistortion, to obtain the third radio frequency signal includes: obtaining the first radio frequency signal, and determining a second minimum mean square error between the first radio frequency signal and the nonlinear signal received by the feedback unit in the corresponding analog processing module; calculating a second nonlinear coefficient based on the second minimum mean square error; and performing, based on the second nonlinear coefficient, the second cancellation processing on the second radio frequency signal obtained through the linear predistortion, to obtain the third radio frequency signal.

In a possible implementation, the method further includes: receiving a second analog signal through an antenna, converting the second analog signal into a second digital signal, and sending the second digital signal to a digital receiving module.

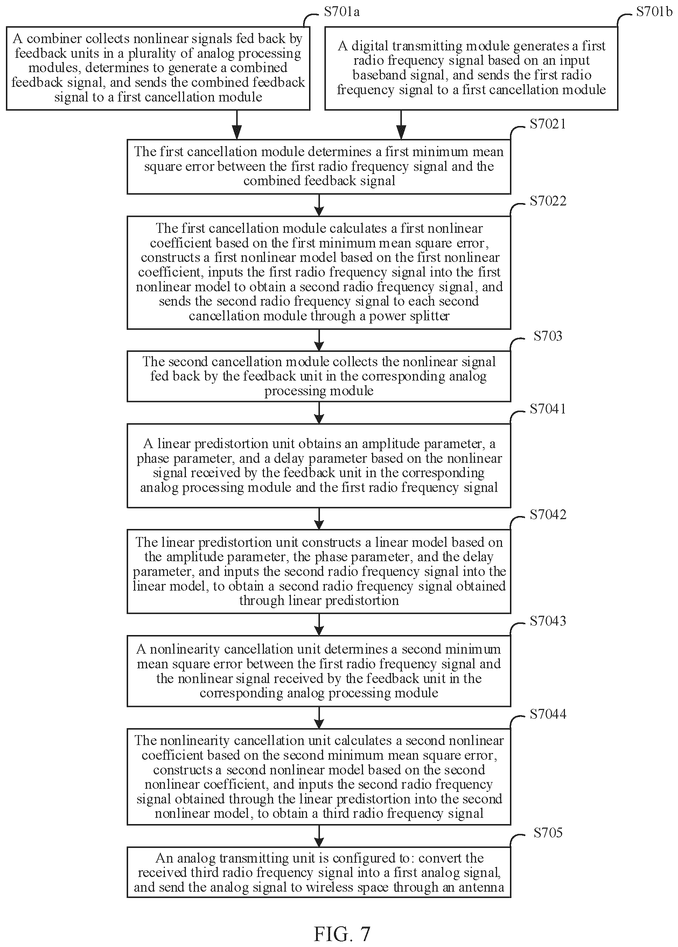

Based on the implementations described in the foregoing embodiment, this application provides a multi-channel nonlinearity cancellation method. The method may be performed by the transmitter described in any one of the foregoing embodiments. FIG. 7 is a flowchart of a multi-channel nonlinearity cancellation method according to an embodiment of this application. The method is specifically described as follows.

Step S701a: A combiner collects nonlinear signals fed back by feedback units in a plurality of analog processing modules, generates a combined feedback signal, and sends the combined feedback signal to a first cancellation module. A switch in the combiner may be connected to the feedback units separately. When a single pole of the single-pole multi-state switch is switched to a first state, a first feedback unit can be connected to the combiner.

Step S701b: A digital transmitting module generates a first radio frequency signal based on an input baseband signal, and sends the first radio frequency signal to a first cancellation module.

Step S7021: The first cancellation module determines a first minimum mean square error between the first radio frequency signal and the combined feedback signal.

Step S7022: The first cancellation module calculates a first nonlinear coefficient based on the first minimum mean square error, constructs a first nonlinear model based on the first nonlinear coefficient, inputs the first radio frequency signal into the first nonlinear model to obtain a second radio frequency signal, and sends the second radio frequency signal to each second cancellation module through a power splitter. The first cancellation module may be configured to address a common part of the nonlinear signals generated by analog transmitting units, and cancel the common part of the nonlinear signals, to implement overall nonlinearity cancellation, improve cancellation performance, and meet an isolation metric of a communication system.

Step S703: The second cancellation module collects the nonlinear signal fed back by the feedback unit in the corresponding analog processing module.

Step S7041: A linear predistortion unit obtains an amplitude parameter, a phase parameter, and a delay parameter based on the nonlinear signal received by the feedback unit in the corresponding analog processing module and the first radio frequency signal.

Step S7042: The linear predistortion unit constructs a linear model based on the amplitude parameter, the phase parameter, and the delay parameter, and inputs the second radio frequency signal into the linear model, to obtain a second radio frequency signal obtained through the linear predistortion. The amplitude parameter, the phase parameter, and the delay parameter may include an adjustable amplitude value, an adjustable phase value, and an adjustable delay value, respectively. The linear model may be constructed based on the parameters. After the second radio frequency signal is input into the linear model, linear predistortion may be performed on the second radio frequency signal, obtaining the second radio frequency signal obtained through the linear predistortion.

Step S7043: A nonlinearity cancellation unit determines a second minimum mean square error between the first radio frequency signal and the nonlinear signal received by the feedback unit in the corresponding analog processing module.

Step S7044: The nonlinearity cancellation unit calculates a second nonlinear coefficient based on the second minimum mean square error, constructs a second nonlinear model based on the second nonlinear coefficient, and inputs the second radio frequency signal obtained through the linear predistortion into the second nonlinear model, to obtain a third radio frequency signal. Nonlinear components generated by analog devices vary widely. In addition, signals arriving at the analog devices also vary widely because the signals are affected by analog links. The second cancellation modules may address differences between the nonlinear signals sent by the corresponding feedback signals. The second cancellation module constructs a nonlinear model based on the second radio frequency signal and the nonlinear signal sent by the corresponding feedback signal, calculates a nonlinear coefficient based on a minimum mean square error, and applies the nonlinear coefficient to construction of the nonlinear model. In this way, a difference of overall nonlinearity cancellation is reduced, interference is canceled more thoroughly and more precisely, linearity of the signals is improved, and nonlinear distortion is reduced.

Step S705: An analog transmitting unit is configured to: convert the received third radio frequency signal into a first analog signal, and transmit the first analog signal through an antenna.

Based on a same technical concept, this application further provides a multi-channel nonlinearity cancellation apparatus. For example, the multi-channel nonlinearity cancellation apparatus 800 may be a chip or chip system. Optionally, in this embodiment of this application, the chip system may include a chip, or may include a chip and another discrete component.

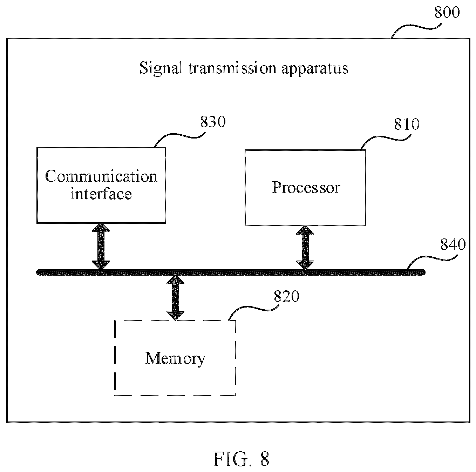

As shown in FIG. 8, the multi-channel nonlinearity cancellation apparatus 800 may include at least one processor 810. Optionally, the processor 810 is coupled to a memory. The memory may be located in the apparatus, or the memory may be integrated with the processor, or the memory may be located outside the apparatus. For example, the multi-channel nonlinearity cancellation apparatus 800 may further include at least one memory 820. The memory 820 stores a computer program, a computer program or instructions, and/or data that are/is necessary for implementing any one of the foregoing examples. The processor 810 may execute the computer program stored in the memory 820, to perform the method in any one of the foregoing examples.

The multi-channel nonlinearity cancellation apparatus 800 may further include a communication interface 830. The multi-channel nonlinearity cancellation apparatus 800 may exchange information with a first device through the communication interface 830. For example, the communication interface 830 may be a transceiver, a circuit, a bus, a module, a pin, or another type of communication interface. When the multi-channel nonlinearity cancellation apparatus 800 is a chip-type apparatus or circuit, the communication interface 830 in the multi-channel nonlinearity cancellation apparatus 800 may alternatively be an input/output circuit, and may input information (or receive information) and output information (or send information). The processor is an integrated processor, a microprocessor, an integrated circuit, or a logic circuit. The processor may determine output information based on input information.

The coupling in this embodiment of this application is indirect coupling or a communication connection between apparatuses, units, or modules, may be in an electrical form, a mechanical form, or another form, and is used for information exchange between the apparatuses, the units, or the modules. The processor 810 may operate cooperatively with the memory 820 and the communication interface 830. A specific connection medium between the processor 810, the memory 820, and the communication interface 830 is not limited in this embodiment of this application.

Optionally, with reference to FIG. 8, the processor 810, the memory 820, and the communication interface 830 are connected to each other by a bus 840. The bus 840 may be a peripheral component interconnect (peripheral component interconnect, PCI) bus, an extended industry standard architecture (extended industry standard architecture, EISA) bus, or the like. Buses may be classified into address buses, data buses, control buses, and the like. For ease of representation, only one thick line is used for representation in FIG. 8, but this does not mean that there is only one bus or only one type of bus.

In this embodiment of this application, the processor 810 may be a general-purpose processor, a digital signal processor, an application-specific integrated circuit, a field programmable gate array or another programmable logic device, a discrete gate or transistor logic device, or a discrete hardware component, and may implement or perform the methods, steps, and logical block diagrams disclosed in embodiments of this application. The general-purpose processor may be a microprocessor, any conventional processor, or the like. The steps in the method disclosed with reference to embodiments of this application may be directly performed by a hardware processor, or may be performed by a combination of hardware in the processor and a software module.

In this embodiment of this application, the memory 820 may be a non-volatile memory, for example, a hard disk drive (hard disk drive, HDD) or a solid-state drive (solid-state drive, SSD), or may be a volatile memory (volatile memory), for example, a random access memory (random access memory, RAM). The memory is any other medium that can carry or store expected program code in a form of instructions or a data structure and that can be accessed by a computer, but is not limited thereto. The memory in this embodiment of this application may alternatively be a circuit or any other apparatus that can implement a storage function, and is configured to store program instructions and/or data.

All or some of the technical solutions provided in embodiments of this application may be implemented by software, hardware, firmware, or any combination thereof. When software is used to implement the technical solutions, all or some of the technical solutions may be implemented in a form of a computer program product. The computer program product includes one or more computer instructions. When the computer program instructions are loaded and executed on a computer, all or some of the procedures or functions according to embodiments of this application are generated. The computer may be a general-purpose computer, a dedicated computer, a computer network, a network management device, a PMU, or another programmable apparatus. The computer instructions may be stored in a computer-readable storage medium or may be transmitted from a computer-readable storage medium to another. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by a computer, or may be a data storage device, such as a server or a data center, integrating one or more usable media. The usable medium may be a magnetic medium (for example, a floppy disk, a hard disk, or a magnetic tape), an optical medium (for example, a digital video disc (digital video disc, DVD)), a semiconductor medium, or the like.

In embodiments of this application, on the premise that there is no logical contradiction, examples may be mutually referenced. For example, methods and/or terms in the method embodiments may be mutually referenced, functions and/or terms in the apparatus embodiments may be mutually referenced, or functions and/or terms in the apparatus examples and the method examples may be mutually referenced.

It is clear that persons skilled in the art can make various modifications and variations to embodiments without departing from the scope of embodiments of this application. In this way, embodiments of this application are intended to cover these modifications and variations of embodiments of this application provided that they fall within the scope of the claims of this application and equivalent technologies.

## Claims

1.    A multi-channel nonlinearity cancellation system, comprising a digital transmitting module, a first cancellation module, a plurality of second cancellation modules, and a plurality of analog processing modules, wherein the plurality of second cancellation modules are connected to the plurality of analog processing modules on a one-to-one basis; each analog processing module comprises an analog transmitting unit and a feedback unit that are connected to each other; the analog transmitting unit in any one of the analog processing modules is configured to: convert a received first digital signal into a first analog signal, and transmit the first analog signal through an antenna; and the feedback unit in any one of the analog processing modules is configured to: collect a nonlinear signal generated when the connected analog transmitting unit performs digital-to-analog conversion, and feed back the collected nonlinear signal to the first cancellation module and the second cancellation module that corresponds to the analog processing module;

    the digital transmitting module is configured to: generate a first radio frequency signal based on an input baseband signal, and send the first radio frequency signal to the first cancellation module;

    the first cancellation module is configured to: perform first cancellation processing on the first radio frequency signal based on the nonlinear signals fed back by the feedback units in the plurality of analog processing modules, to obtain a second radio frequency signal, and send the second radio frequency signal to each second cancellation module; and

    each second cancellation module is configured to: perform second cancellation processing on the second radio frequency signal based on the nonlinear signal fed back by the feedback unit in the corresponding analog processing module, to obtain a third radio frequency signal, and send the third radio frequency signal to the analog transmitting unit in the corresponding analog processing module, wherein the third radio frequency signal is a first digital signal.

2.    The system according to claim 1, wherein the multi-channel nonlinearity cancellation system further comprises a combiner;

    the feedback unit in any one of the analog processing modules is configured to feed back the collected nonlinear signal to the combiner;

    the combiner is configured to: combine the received nonlinear signals fed back by the feedback units in the plurality of analog processing modules, to generate a combined feedback signal, and send the combined feedback signal to the first cancellation module; and

    the first cancellation module is specifically configured to:

        determine a first minimum mean square error between the first radio frequency signal and the combined feedback signal;

        calculate a first nonlinear coefficient based on the first minimum mean square error; and

        perform the first cancellation processing on the first radio frequency signal based on the first nonlinear coefficient, to obtain the second radio frequency signal.

3.    The system according to claim 1 or 2, wherein any one of the second cancellation modules comprises a linear predistortion unit and a nonlinearity cancellation unit;

    the linear predistortion unit is configured to perform linear predistortion on the second radio frequency signal, to obtain a second radio frequency signal obtained through the linear predistortion; and

    the nonlinearity cancellation unit is configured to perform, based on the nonlinear signal fed back by the feedback unit in the corresponding analog processing module, the second cancellation processing on the second radio frequency signal obtained through the linear predistortion, to obtain the third radio frequency signal.

4. The system according to claim 3, wherein the linear predistortion unit is connected to the digital transmitting module, and is specifically configured to:

obtain the first radio frequency signal, and obtain an amplitude parameter, a phase parameter, and a delay parameter based on the nonlinear signal fed back by the feedback unit in the corresponding analog processing module and the first radio frequency signal; and
perform the linear predistortion on the second radio frequency signal based on the amplitude parameter, the phase parameter, and the delay parameter, to obtain the second radio frequency signal obtained through the linear predistortion.

5. The system according to claim 3 or 4, wherein the nonlinearity cancellation unit is connected to the digital transmitting module, and is specifically configured to:

obtain the first radio frequency signal, and determine a second minimum mean square error between the first radio frequency signal and the nonlinear signal received by the feedback unit in the corresponding analog processing module;
calculate a second nonlinear coefficient based on the second minimum mean square error; and
perform, based on the second nonlinear coefficient, the second cancellation processing on the second radio frequency signal obtained through the linear predistortion, to obtain the third radio frequency signal.

6. The system according to any one of claims 1 to 5, wherein the multi-channel nonlinearity cancellation system further comprises a digital receiving module, and each analog processing module further comprises an analog receiving unit; and
the analog receiving unit is configured to: receive a second analog signal through an antenna, convert the second analog signal into a second digital signal, and send the second digital signal to the digital receiving module.

7. The system according to any one of claims 1 to 6, wherein the multi-channel nonlinearity cancellation system further comprises a power splitter, one end of the power splitter is connected to the first cancellation module, the other end of the power splitter is connected to each second cancellation module, and the power splitter is configured to: receive the second radio frequency signal from the first cancellation module, and send the second radio frequency signal to each second cancellation module.

8. The system according to any one of claims 1 to 7, wherein each analog transmitting unit comprises a digital-to-analog conversion circuit and a power amplification circuit, and the digital-to-analog conversion circuit is configured to convert the first digital signal into the first analog signal; and
the power amplification circuit is configured to amplify power of the first analog signal.

9. A multi-channel nonlinearity cancellation method, wherein the method comprises:

generating a first radio frequency signal based on an input baseband signal, and sending the first radio frequency signal to a first cancellation module;
performing first cancellation processing on the first radio frequency signal based on nonlinear signals fed back by feedback units in a plurality of analog processing modules, to obtain a second radio frequency signal, and sending the second radio frequency signal to each second cancellation module; and
performing second cancellation processing on the second radio frequency signal based on the nonlinear signal fed back by the feedback unit in the corresponding analog processing module, to obtain a third radio frequency signal, and sending the third radio frequency signal to an analog transmitting unit in the corresponding analog processing module.

10. The method according to claim 9, wherein the performing first cancellation processing on the first radio frequency signal based on nonlinear signals fed back by feedback units in a plurality of analog processing modules, to obtain a second radio frequency signal comprises:

combining the received nonlinear signals fed back by the feedback units in the plurality of analog processing modules, to generate a combined feedback signal;
determining a first minimum mean square error between the first radio frequency signal and the combined feedback signal;
calculating a first nonlinear coefficient based on the first minimum mean square error; and
performing the first cancellation processing on the first radio frequency signal based on the first nonlinear coefficient, to obtain the second radio frequency signal.

**11.** The method according to claim 9 or 10, wherein the performing second cancellation processing on the second radio frequency signal based on a nonlinear signal fed back by a feedback unit in a corresponding analog processing module comprises:

performing linear predistortion on the second radio frequency signal, to obtain a second radio frequency signal obtained through the linear predistortion; and
performing, based on the nonlinear signal fed back by the feedback unit in the corresponding analog processing module, the second cancellation processing on the second radio frequency signal obtained through the linear predistortion, to obtain the third radio frequency signal.

**12.** The method according to claim 11, wherein the performing linear predistortion on the second radio frequency signal, to obtain a second radio frequency signal obtained through the linear predistortion comprises:

obtaining the first radio frequency signal, and obtaining an amplitude parameter, a phase parameter, and a delay parameter based on the nonlinear signal fed back by the feedback unit in the corresponding analog processing module and the first radio frequency signal; and
performing the linear predistortion on the second radio frequency signal based on the amplitude parameter, the phase parameter, and the delay parameter, to obtain the second radio frequency signal obtained through the linear predistortion.

**13.** The method according to claim 11, wherein the performing, based on the nonlinear signal fed back by the feedback unit in the corresponding analog processing module, the second cancellation processing on the second radio frequency signal obtained through the linear predistortion, to obtain the third radio frequency signal comprises:

obtaining the first radio frequency signal, and determining a second minimum mean square error between the first radio frequency signal and the nonlinear signal received by the feedback unit in the corresponding analog processing module;
calculating a second nonlinear coefficient based on the second minimum mean square error; and
performing, based on the second nonlinear coefficient, the second cancellation processing on the second radio frequency signal obtained through the linear predistortion, to obtain the third radio frequency signal.

**14.** The method according to any one of claims 9 to 13, wherein the method further comprises:
receiving a second analog signal through an antenna, converting the second analog signal into a second digital signal, and sending the second digital signal to a digital receiving module.

**15.** A multi-channel nonlinearity cancellation apparatus, comprising a processor, wherein the processor is coupled to a memory, and the processor is configured to invoke computer program instructions stored in the memory, to perform the method according to any one of claims 9 to 14.

**16.** A multi-channel nonlinearity cancellation apparatus, comprising a unit configured to perform the method according to any one of claims 9 to 14.

**17.** A computer-readable storage medium, wherein the computer-readable storage medium stores instructions, and when the instructions are run on a computer, the computer is enabled to perform the method according to any one of claims 9 to 14.

**18.** A computer program product, comprising instructions, wherein when the instructions are run on a computer, the computer is enabled to perform the method according to any one of claims 9 to 14.

FIG. 1

FIG. 2

FIG. 3

FIG. 4

FIG. 5

Multi-channel nonlinearity cancellation system 200

Baseband signal → Digital transmitting module 201 → First cancellation module 202

Digital receiving module 206

Combiner 205

204 — Analog transmitting unit 2041 / Feedback unit 2042 / Analog receiving unit 2043

203 — Linear predistortion unit 2031 / Nonlinearity cancellation unit 2032

204 — Analog transmitting unit 2041 / Feedback unit 2042 / Analog receiving unit 2043

203 — Linear predistortion unit 2031 / Nonlinearity cancellation unit 2032

FIG. 6

S701a

A combiner collects nonlinear signals fed back by feedback units in a plurality of analog processing modules, determines to generate a combined feedback signal, and sends the combined feedback signal to a first cancellation module

S701b

A digital transmitting module generates a first radio frequency signal based on an input baseband signal, and sends the first radio frequency signal to a first cancellation module

S7021

The first cancellation module determines a first minimum mean square error between the first radio frequency signal and the combined feedback signal

S7022

The first cancellation module calculates a first nonlinear coefficient based on the first minimum mean square error, constructs a first nonlinear model based on the first nonlinear coefficient, inputs the first radio frequency signal into the first nonlinear model to obtain a second radio frequency signal, and sends the second radio frequency signal to each second cancellation module through a power splitter

S703

The second cancellation module collects the nonlinear signal fed back by the feedback unit in the corresponding analog processing module

S7041

A linear predistortion unit obtains an amplitude parameter, a phase parameter, and a delay parameter based on the nonlinear signal received by the feedback unit in the corresponding analog processing module and the first radio frequency signal

S7042

The linear predistortion unit constructs a linear model based on the amplitude parameter, the phase parameter, and the delay parameter, and inputs the second radio frequency signal into the linear model, to obtain a second radio frequency signal obtained through linear predistortion

S7043

A nonlinearity cancellation unit determines a second minimum mean square error between the first radio frequency signal and the nonlinear signal received by the feedback unit in the corresponding analog processing module

S7044

The nonlinearity cancellation unit calculates a second nonlinear coefficient based on the second minimum mean square error, constructs a second nonlinear model based on the second nonlinear coefficient, and inputs the second radio frequency signal obtained through the linear predistortion into the second nonlinear model, to obtain a third radio frequency signal

S705

An analog transmitting unit is configured to: convert the received third radio frequency signal into a first analog signal, and send the analog signal to wireless space through an antenna

FIG. 7

800

Signal transmission apparatus

830

Communication interface

810

Processor

840

820

Memory

FIG. 8

## INTERNATIONAL SEARCH REPORT

| International application No. |
| --- |
| **PCT/CN2023/130131** |

| A. | CLASSIFICATION OF SUBJECT MATTER |
| --- | --- |

H04B1/04(2006.01)i

According to International Patent Classification (IPC) or to both national classification and IPC

| B. | FIELDS SEARCHED |
| --- | --- |

Minimum documentation searched (classification system followed by classification symbols)

IPC: H04B H04Q H04W

Documentation searched other than minimum documentation to the extent that such documents are included in the fields searched

Electronic data base consulted during the international search (name of data base and, where practicable, search terms used)

CNTXT, ENTXTC, WPABS, VEN, ENTXT: 多, 两, 通道, 通路, 链路, 非线性, 对消, 消除, 模拟, 数字, 反馈, 回馈, multi+, two, link+, non-linear, cancel, analog, digital, feedback, DAC, ADC

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| A | CN 102055411 A (CHENGDU KAITENG SIFANG DIGITAL RADIO & TELEVISION EQUIPMENT CO., LTD.) 11 May 2011 (2011-05-11)<br>claims 1-7, and description, paragraphs [0057]-[0121] | 1-18 |
| A | CN 109428610 A (HUAWEI TECHNOLOGIES CO., LTD.) 05 March 2019 (2019-03-05)<br>entire document | 1-18 |
| A | EP 1755296 A2 (BROADCOM CORP.) 21 February 2007 (2007-02-21)<br>entire document | 1-18 |
| A | US 10616009 B1 (ROCKWELL COLLINS, INC.) 07 April 2020 (2020-04-07)<br>entire document | 1-18 |

☐ Further documents are listed in the continuation of Box C.　　☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **04 January 2024** | **16 January 2024** |

| Name and mailing address of the ISA/CN | Authorized officer |
| --- | --- |
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**
Information on patent family members

International application No.

**PCT/CN2023/130131**

| Patent document cited in search report | | | Publication date (day/month/year) | Patent family member(s) | | | Publication date (day/month/year) |
|---|---|---|---|---|---|---|---|
| CN | 102055411 | A | 11 May 2011 | None | | | |
| CN | 109428610 | A | 05 March 2019 | None | | | |
| EP | 1755296 | A2 | 21 February 2007 | US | 2002060827 | A1 | 23 May 2002 |
| | | | | WO | 0243340 | A2 | 30 May 2002 |
| | | | | EP | 1344361 | A2 | 17 September 2003 |
| US | 10616009 | B1 | 07 April 2020 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202211517425